# EUROPÄISCHE PATENTANMELDUNG

(11) **EP 1 276 359 A2**
(43) Veröffentlichungstag der Anmeldung: **15.01.2003**
(21) Anmeldenummer: 02015025.6
(22) Anmeldetag: 05.07.2002
(51) Int. Cl.: H05K 3/38

(54) **Verfahren zur Herstellung eines flexiblen Laminates**

(30) Priorität: 09.07.2001 DE 10133250
(71) Anmelder: Vipem Hackert GmbH, 08223 Grünbach (DE)
(72) Erfinder: Hackert, Jürgen, 08223 Grünbach (DE)
(74) Vertreter: LOUIS, PÖHLAU, LOHRENTZ & SEGETH

(57) **Zusammenfassung**

Es wird ein Verfahren zur Herstellung eines elektrischen oder elektronischen Kabelbaums in Form eines flexiblen Laminates (58) mit einer zwischen einer Grundschicht (50) und einer Deckschicht (56) vorgesehenen, dem Kabelbaum entsprechend strukturierten Metallschicht (14) beschrieben, wobei eine Metallfolie (14) an ihren beiden Seiten (24, 38) jeweils mit einer Blumenkohlstruktur (26, 40) ausgebildet wird. Die Blumenkohlstrukturen (26, 40) werden jeweils mit einer Blackoxid-Beschichtung (46, 48) bedeckt. Eine Seite (24) der Metallfolie (14) wird anschließend mit einer ersten Schicht (50) aus einem ersten Kunststoff-Material beschichtet. Die Metallfolie (14) wird danach dem Kabelbaum entsprechend strukturiert. Abschließend wird die die Metallstruktur (52) aufweisende Seite (38) mit einer zweiten Schicht (56) aus einem zweiten Kunststoff-Material bedeckt. Die zweite Kunststoffschicht (56) verbindet sich dabei mit der Metallstruktur (52) und an den von der Metallstruktur (52) frei bleibenden Flächenbereich mit der ersten Kunststoffschicht (50).

## Beschreibung

Die Erfindung betrifft ein Verfahren zur Herstellung eines elektrischen oder elektronischen Kabelbaumes in Form eines flexiblen Laminates mit einer zwischen einer Grundschicht und einer Deckschicht vorgesehenen strukturierten Metallschicht.

Für Kabelbäume in Kraftfahrzeugen, in Videokameras, in elektronischen Geräten sowie bei anderen Anwendungen kommen flexible Laminate zur Anwendung, die beispielsweise eine flexible thermostabile Kunststoff-Folie aufweisen, die an einer Oberfläche mit Metallfolien-Leiterbahnen versehen ist. Die Metallfolien-Leiterbahnen sind an der genannten Oberfläche der thermostabilen Kunststoff-Folie mit Hilfe eines Klebers festgeklebt. Die Abzugfestigkeit derartiger an der Kunststoff-Folie festgeklebter strukturierter Metallfolien ist gering, sie beträgt beispielsweise größenordnungsmäßig 0,5 N/mm². Zur Verbesserung der Abzugfestigkeit einer auf einer Kunststoff-Folie festgeklebten strukturierten Metallfolie wurde auch vorgeschlagen, die Oberfläche der Kunststoff-Folie mit Hilfe eines Lasers mit kleinen Sacklöchern auszubilden, um die Oberfläche der Kunststoff-Folie aufzurauhen. Die Herstellung solcher kleiner Sacklöcher ist sehr aufwendig. Die Abzugfestigkeit der an einer solchermaßen vorbearbeiteten Kunststoff-Folie festgeklebten strukturierten Metallfolie beträgt größenordnungsmäßig 0,1 bis 1 N/mm².

Ein weiterer Mangel der Verbindung einer strukturierten Metallfolie mit einer flexiblen thermostabilen Kunststoff-Folie mittels eines Klebers - neben dieser relativ geringen Abzugfestigkeit - besteht darin, daß die Abzug- bzw. Haftfestigkeit über einen Temperaturbereich von beispielsweise -40 °C bis +120 °C nicht konstant ist, so daß eine zuverlässige Verbindung zwischen der thermostabilen Kunststoff-Folie und der strukturierten Metallfolie, bei der es sich beispielsweise um eine Kupfer- oder Nickel-Folie od. dgl. handelt, über einen solchen weiteren Temperaturbereich nicht zuverlässig gewährleistbar ist.

Des weiteren ist ein Laminat mit einer flexiblen thermostabilen Kunststoff-Folie bekannt, die mindestens einseitig eine nadelartig aufgerauhte Oberfläche aufweist, die mit einer Metall-Dünnschicht bedeckt ist. Die nadelartige Aufrauhung der Oberfläche der thermostabilen Kunststoff-Folie wird beispielsweise in einem Ätzvorgang durchgeführt. Die Nadeln besitzen beispielsweise einen Durchmesser von größenordnungsmäßig 2 µm, sie stehen größenordnungsmäßig 5 bis 10 µm über die Kunststoff-Folie über. Pro cm² können beispielsweise (10 bis 15) .10⁶ Nadeln vorgesehen sein. Die nadelartig aufgerauhte Oberfläche der thermostabilen Kunststoff-Folie, die vorzugsweise aus Polyimid besteht, wird beispielsweise durch Kathodenzerstäuben mit der Metall-Dünnschicht bedeckt. Die Dicke der Metall-Dünnschicht beträgt beispielsweise 0,7 bis 1,0 µm.

Die DE 198 57 157 A1 beschreibt ein Verfahren zur Herstellung einer selbsttragenden Metallfolie, die aufgrund ihres Gefüges scharfrandig strukturierbar ist. Diese bekannte Metallfolie besteht aus einer Metall-Grundschicht und einer auf einer Seite der Metall-Grundschicht fixierten Blumenkohlstruktur. Die Metall-Grundschicht wird durch galvanische Abscheidung der entsprechenden Metall-Ionen eines Elektrolyt-Bades auf einer sich drehenden Walzenkathode hergestellt. Zur Walzenkathode ist ein Anodenkorb benachbart, der zur Walzenkathode konzentrisch vorgesehen ist. Zur Ausbildung der Blumenkohlstruktur an der einen Seite der Metall-Grundschicht ist der Walzenkathode eng benachbart eine Zusatzanode zugeordnet, die an eine vom Anodenkorb unabhängige zweite Gleichspannungsquelle angeschlossen ist. Zur weiteren Verbesserung der Haftfestigkeit der einseitig mit der Blumenkohlstruktur versehenen Metallfolie wird diese durch ein Blackoxid-Bad hindurchbewegt, um an den Blumenkohlpartikeln der einseitigen Blumenkohlstruktur Mikrofäden bzw. - härchen auszubilden.

Ein Verfahren zur Herstellung einer selbsttragenden Kupfer-Folie, die aufgrund ihres Gefüges scharfrandig prägbar ist, wobei auf einer in ein Kupferelektrolyt-Bad eintauchenden und von einem Anodenkorb umgebenen rotierenden Kathodenwalze die Kupfer-Folie galvanisch abgeschieden und von der Kathodenwalze abgelöst wird, ist beispielsweise auch aus der DE 199 37 843 C1 bekannt. Bei diesem bekannten Verfahren wird ein Standard-Kupferelektrolyt-Bad mit solchen Zusätzen verwendet, daß sich ein dentritisches Wachstum der Kupfer-Folie mit einer lamellaren Gefügestruktur ergibt. Aus dieser lamellaren Gefügestruktur resultiert eine vergrößerte Härte der Kupfer-Folie. Diese vergrößerte Härte geht mit einer erhöhten Sprödigkeit einher, durch die die Konturschärfe beim Prägen der Kupfer-Folie verbessert wird.

Die DE 79 06 610 U1 beschreibt einen mit einer thermoplastischen Masse beschichteten, nach Art eines Blechbandes ausgebildeten metallischen Träger insbesondere für eine Dachhaut. Bei diesem beschichteten Träger handelt es sich also um ein Bauelement für das Baugewerbe. Dieser bekannte nach Art eines Blechbandes ausgebildete Träger ist mit im wesentlichen gleichmäßig verteilt angeordneten Löchern versehen. Auf beiden Seiten des gelochten Trägers sind Teile der thermoplastischen Masse über diese Löcher hinweg miteinander verbunden. Dort wird also ein mit Löchern ausgebildeter Träger, bei dem es sich um ein Lochblech oder um ein Drahtgeflecht handeln kann, verwendet, der an seinen beiden Seiten gleichzeitig mit einer thermoplastischen Masse versehen wird. Die beidseitigen thermoplastischen Massen verbinden sich durch die Löcher des Trägers hindurch fest miteinander. Mit einem elektrischen oder einem elektronischen Kabelbaum hat dieser beschichtete metallische Träger insbesondere für eine Dachhaut keine Gemeinsamkeiten. Gleiches gilt für das aus der DE 42 28 444 A1 bekannte Lochblech mit beidseitiger Beschichtung aus mindestens teilweise thermoplastischem Kunststoff, wobei die Löcher des Lochbleches unter gegenseitiger Verbindung der beiden Schichten mit Kunststoff ausgefüllt sind. Eine Seite des Lochbleches weist eine das Entweichen von Luft beim Beschichten ermöglichende strukturierte Oberflächenschicht auf. Diese Oberflächenschicht ist vorzugsweise von einem Faservlies oder Gewebe gebildet.

Der Erfindung liegt die Aufgabe zugrunde, ein Verfahren der eingangs genannten Art zu schaffen, mit dem ein elektrischer oder elektronischer Kabelbaum in Forme eines flexibles Laminates einfach und preisgünstig realisierbar ist, wobei der Verbund des Laminates, d.h. der Verbund zwischen der dem Kabelbaum entsprechenden strukturierten Metallschicht und der Grund- und Deckschicht über einen weiten Temperaturbereich von beispielsweise -40 °C bis +120 °C optimale Eigenschaften aufweist.

Diese Aufgabe wird bei einem Verfahren der eingangs genannten Art erfindungsgemäß dadurch gelöst, daß an beiden Hauptflächen einer Metallfolie jeweils eine Blumenkohlstruktur ausgebildet wird, die mit einer Blackoxid-Beschichtung bedeckt wird, daß eine Hauptfläche der mit einer Blumenkohlstruktur und einer Blackoxid-Beschichtung versehenen Metallfolie anschließend mit einer ersten Schicht aus einem ersten Kunststoff-Material beschichtet wird, daß die Metallfolie danach strukturiert wird, so daß an der ersten Schicht aus dem ersten Kunststoff-Material eine dem Kabelbaum entsprechende Metallstruktur verbleibt, daß dann das Zwischengebilde aus der ersten Schicht aus dem ersten Kunststoff-Material und der strukturierten Metallfolie an der die Metallstruktur aufweisenden Seite mit einer zweiten Schicht aus einem zweiten Kunststoff-Material beschichtet wird, wobei sich die zweite Schicht aus dem zweiten Kunststoff-Material mit der Metallstruktur und an den von der Metallstruktur freien Flächenbereichen mit der ersten Schicht aus dem ersten Kunststoff-Material mechanisch fest verbindet.

Die Blumenkohlstrukturen an den beiden sich gegenüberliegenden Hauptflächen der Metallfolie sind mit hoher Produktivität einfach herstellbar. Gleiches gilt für die Blackoxid-Beschichtung jeder der beiden Blumenkohlstrukturen der Metallfolie. Die Beschichtung der Metallfolie an einer ihrer beiden Hauptflächen mit dem ersten Kunststoff-Material ist ebenfalls einfach und zeitsparend mit hoher Produktivität möglich.

Bei der Durchführung des erfindungsgemäßen Verfahrens kann eine galvanisch hergestellte Metallfolie verwendet werden. Diese Metallfolie kann von einer handelsüblichen Metallfolie gebildet sein. Die handelsübliche Metallfolie kann dann zu einem späteren Zeitpunkt mit den Blumenkohlstrukturen und den Blackoxid-Beschichtungen versehen werden. Desgleichen ist es möglich, daß die Metallfolie unmittelbar nach ihrer galvanischen Herstellung direkt mit den Blumenkohlstrukturen ausgebildet und mit der Blackoxid-Beschichtung versehen wird.

Die Beschichtung der einen Hauptfläche der beidseitig jeweils mit einer Blumenkohlstruktur und einer Blackoxid-Beschichtung versehenen Metallfolie kann durch Lackieren mit dem ersten Kunststoff-Material erfolgen. Diese Beschichtung kann auch durch Extrusion des ersten Kunststoff-Materials oder durch einen Druckvorgang erfolgen. Bei diesem Druckvorgang kann es sich um einen Tampon-Druck, einen Siebdruck bzw. Rakelvorgang od. dgl. handeln.

Die dem Kabelbaum entsprechende Strukturierung der mit der ersten Schicht aus dem ersten Kunststoff-Material großflächig und festhaftend verbundenen Metallfolie kann durch Masken-Ätzen, d.h. durch ein an sich bekanntes Photo-Lithographie-Verfahren, erfolgen. Selbstverständlich kann auch ein anderes an sich bekanntes Strukturierungsverfahren zur Anwendung gelangen. Hierbei kann es sich beispielsweise um ein Laser-Verfahren od. dgl. handeln.

Die der ersten Schicht in bezug auf die strukturierte Metallfolie gegenüberliegende zweite Schicht aus dem zweiten Kunststoff-Material kann auf die Metallstruktur durch Lackieren, Extrudieren oder Drucken aufgebracht werden. Auf diese Weise ist es möglich, eine zweite Schicht mit einer von der Strukturierung der Metallfolie unabhängigen glatten Außenoberfläche zu realisieren.

Mit Hilfe des erfindungsgemäßen Verfahrens ist es in vorteilhafter Weise möglich, einen elektrischen oder elektronischen Kabelbaum in Form eines flexiblen Laminates mit einer zwischen einer Grund- und einer Deckschicht bzw. einer ersten und zweiten Kunststoffschicht vorgesehenen, dem Kabelbaum entsprechend strukturierten Metallschicht zu verwirklichen, das mit relativ geringen Herstellungskosten mit hoher Produktivität realisierbar ist, wobei die elektrischen und mechanischen Eigenschaften des Kabelbaum-Laminates über einen weiten Temperaturbereich von beispielsweise -40 °C bis +120 °C optimale Werte besitzen.

Das erfindungsgemäß hergestellte Laminat kommt beispielsweise bei elektronischen Kabelbäumen in Form von Bußleitungen usw. zur Anwendung.

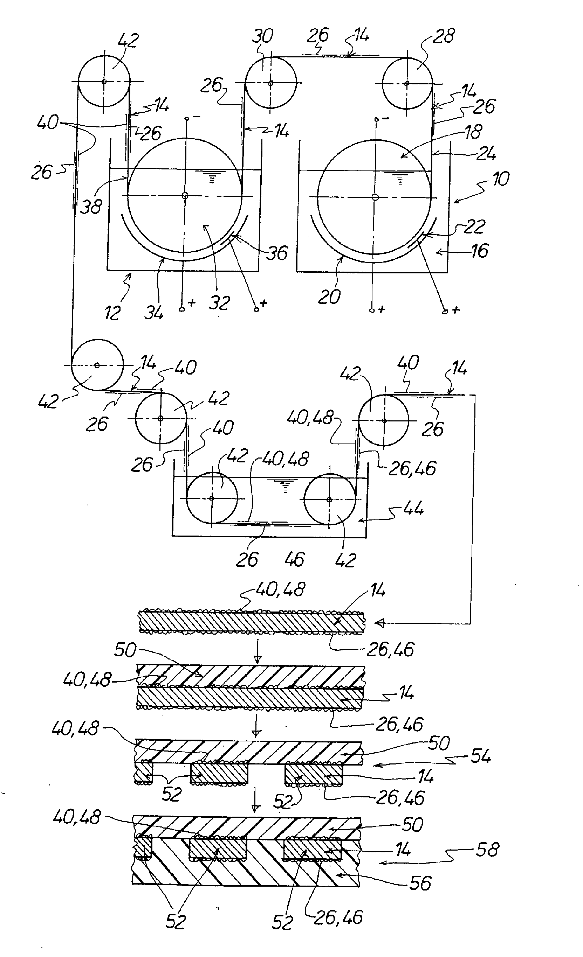

Weitere Einzelheiten, Merkmale und Vorteile ergeben sich aus der nachfolgenden Beschreibung einer in der Zeichnung schematisch dargestellten Vorrichtung zur Durchführung des erfindungsgemäßen Verfahrens sowie der wesentlichen Verfahrensschritte anhand von abschnittweise und geschnitten stark vergrößert gezeichneten Zwischengebilden bis hin zum fertigen flexiblen Laminat mit strukturierter Metallschicht zwischen Grund- und Deckschicht.

Die Figur zeigt in einer schematischen Darstellung einen ersten Bad-Behälter 10 und einen zweiten Bad-Behälter 12 zur Herstellung einer Metallfolie 14. Der erste Bad-Behälter 10 ist mit einem Elektrolyten 16 gefüllt, der entsprechende Metall-Ionen enthält. Im ersten Bad-Behälter 10 ist eine Walzenkathode 18 drehbar angeordnet. Die Walzenkathode 18 ist von einem Anodenkorb 20 umgeben. Zusätzlich zum Anodenkorb 20 ist zwischen diesem und der Walzenkathode 18 eine Zusatzanode 22 angeordnet. Die Zusatzanode 22 ist dazu vorgesehen, auf der dem Anodenkorb 20 bzw. der Zusatzanode 22 zugewandten Seite 24 der auf der Walzenkathode 18 abgeschiedenen und von dieser abgezogenen Metallfolie 14 eine Blumenkohlstruktur 26 festhaftend auszubilden. Die Blumenkohlstruktur 26 ist durch eine strichlierte Linie angedeutet.

Die auf der Seite 24 mit der Blumenkohlstruktur 26 versehene Metallfolie 14 wird um Umlenkrollen 28 und 30 umgelenkt und in den zweiten Bad-Behälter 12 eingeleitet. Der zweite Bad-Behälter 12 ist ebenfalls mit dem Elektrolyten 16 gefüllt. Im zweiten Bad-Behälter 12 ist eine Walzenkathode 32 drehbar gelagert. Die Walzenkathode 32 ist von einem Anodenkorb 34 umgeben. Zwischen der Walzenkathode 32 und dem Anodenkorb 34 ist eine Zusatzanode 36 angeordnet. Mit Hilfe der Zusatzanode 36 wird auf der der Seite 24 gegenüberliegenden zweiten Seite 38 der Metallfolie 14 eine zweite Blumenkohlstruktur 40 festhaftend hergestellt.

Der erste und der zweite Bad-Behälter 10 und 12 können auch zu einem gemeinsamen Behälter zusammengefaßt sein.

Die in Vorschubrichtung der Metallfolie 14 stromabwärts nach dem zweiten Bad-Behälter 12 an ihren beiden Seiten 24 und 38 jeweils mit einer Blumenkohlstruktur 26, 40 ausgebildete Metallfolie 14 wird dann um Umlenkrollen 42 umgelenkt und durch ein Blackoxid-Bad 44 hindurch bewegt, um die beidseitig haftfest mit je einer Blumenkohlstruktur 26 und 40 versehene Metallfolie 14 auf ihren beiden Seiten jeweils mit einer Blackoxid-Beschichtung 46 und 48 zu versehen. Ein Abschnitt der Metallfolie 14 mit den beiden Blumenkohlstrukturen 26 und 40 und den Blackoxid-Beschichtungen 46 und 48 ist in der Zeichnungsfigur stark vergrößert und nicht maßstabgetreu längsgeschnitten dargestellt.

Eine Seite, beispielsweise die Seite 24, der mit Blumenkohlstrukturen 26 und 40 und Blackoxid-Beschichtungen 46 und 48 versehenen Metallfolie 14 wird dann mit einer ersten Schicht 50 aus einem ersten Kunststoff-Material beschichtet.

Anschließend wird die Metallfolie 14 dem herzustellenden Kabelbaum entsprechend strukturiert, so daß an der ersten Schicht 50 aus dem ersten Kunststoff-Material eine Metallstruktur 52 verbleibt. Bei dieser Metallstruktur 52 kann es sich beispielsweise um voneinander beabstandete und zueinander parallel verlaufende Leiterbahnen eines Kabelbaumes, einer Busleitung od. dgl. handeln.

Das in der Zeichnungsfigur mit der Bezugsziffer 54 bezeichnete Zwischengebilde aus der ersten Schicht 50 aus dem ersten Kunststoff-Material und der strukturierten Metallfolie 14 an der die Metallstruktur 52 aufweisenden Seite 24 wird dann mit einer zweiten Schicht 56 aus einem zweiten Kunststoff-Material beschichtet. Bei diesem zweiten Kunststoff-Material kann es sich um ein vom ersten Kunststoff-Material der ersten Schicht 50 verschiedenes oder um dasselbe Kunststoff-Material handeln. Die zweite Schicht 56 verbindet sich mit der Metallstruktur 52 und mit den von der Metallstruktur 52 freibleibenden Bereichen der ersten Schicht 50 aus dem ersten Kunststoff-Material. Das solchermaßen hergestellte flexible Kabelbaum-Laminat 58 weist bei geringen Produktionskosten über einen weiten Temperaturbereich ausgezeichnete mechanische und physikalische Eigenschaften auf.

## Patentansprüche

1. Verfahren zur Herstellung eines elektrischen oder elektronischen Kabelbaumes in Form eines flexiblen Laminates (58) mit einer zwischen einer Grundschicht (50) und einer Deckschicht (56) vorgesehenen, dem Kabelbaum entsprechend strukturierten Metallschicht (52),
**dadurch gekennzeichnet ,**
**daß** an beiden Seiten (24, 38) einer Metallfolie (14) jeweils eine Blumenkohlstruktur (26, 40) ausgebildet wird, die jeweils mit einer Blackoxid-Beschichtung (46, 48) bedeckt wird, daß eine Seite (24) der mit einer Blumenkohlstruktur (26) und einer Blackoxid-Beschichtung (46) versehenen Metallfolie (14) anschließend mit einer ersten Schicht (50) aus einem ersten Kunststoff-Material beschichtet wird, daß die Metallfolie (14) danach strukturiert wird, so daß an der ersten Schicht (50) aus dem ersten Kunststoff-Material eine Metallstruktur (52) verbleibt, daß dann das Zwischengebilde (54) aus der ersten Schicht (50) aus dem ersten Kunststoff-Material und der strukturierten Metallfolie (14) an der die Metallstruktur (52) aufweisenden Seite (38) mit einer zweiten Schicht (56) aus einem zweiten Kunststoff-Material bedeckt wird, wobei sich die zweite Schicht (56) aus dem zweiten Kunststoff-Material mit der Metallstruktur (52) und an den von der Metallstruktur (52) freien Flächenbereichen mit der ersten Schicht (50) aus dem ersten Kunststoff-Material fest verbindet.

2. Verfahren nach Anspruch 1,
**dadurch gekennzeichnet ,**
**daß** eine galvanisch hergestellte Metallfolie (14) verwendet wird.

3. Verfahren nach Anspruch 1,
**dadurch gekennzeichnet ,**
**daß** die Metallfolie (14) während ihrer galvanischen Herstellung mit den Blumenkohlstrukturen (26, 40) ausgebildet wird.

4. Verfahren nach Anspruch 1,
**dadurch gekennzeichnet ,**
**daß** die Beschichtung der einen Seite (24) der mit den Blumenkohlstrukturen (26, 40) und den Blackoxid-Beschichtungen (46, 48) versehenen Metallfolie (14) durch Lackieren mit dem ersten Kunststoff-Material erfolgt.

5. Verfahren nach Anspruch 1,
**dadurch gekennzeichnet ,**
**daß** die Beschichtung der einen Seite (24) der mit den Blumenkohlstrukturen (26, 40) und den Blackoxid-Beschichtungen (46, 48) versehenen Metallfolie (14) durch Extrusion des ersten Kunststoff-Materials erfolgt.

6. Verfahren nach Anspruch 1,
**dadurch gekennzeichnet ,**
**daß** die Beschichtung der einen Seite (24) der mit den Blumenkohlstrukturen (26, 40) und den Blackoxid-Beschichtungen (46, 48) versehenen Metallfolie (14) durch einen Druckvorgang erfolgt.

7. Verfahren nach Anspruch 1,
**dadurch gekennzeichnet ,**
**daß** die Strukturierung der Metallfolie (14) durch Masken-Ätzen erfolgt.

8. Verfahren nach Anspruch 1,
**dadurch gekennzeichnet ,**
**daß** das zweite Kunststoff-Material der zweiten Schicht (56) auf die Metallstruktur (52) durch Lackieren aufgebracht wird.

9. Verfahren nach Anspruch 1,
**dadurch gekennzeichnet ,**
**daß** das zweite Kunststoff-Material der zweiten Schicht (56) auf die Metallstruktur (52) durch Extrudieren aufgebracht wird.

10. Verfahren nach Anspruch 1,
**dadurch gekennzeichnet ,**
**daß** das zweite Kunststoff-Material der zweiten Schicht (56) auf die Metallstruktur (52) durch Drucken aufgebracht wird.
